(19) Europäisches Patentamt
European Patent Office
Office européen des brevets

(11) EP 1 062 604 B1

(12) **EUROPÄISCHE PATENTSCHRIFT**

(45) Veröffentlichungstag und Bekanntmachung des Hinweises auf die Patenterteilung:
**07.11.2001 Patentblatt 2001/45**

(21) Anmeldenummer: **99911580.1**

(22) Anmeldetag: **29.01.1999**

(51) Int Cl.$^{7}$: **G06F 17/50**

(86) Internationale Anmeldenummer:
**PCT/DE99/00239**

(87) Internationale Veröffentlichungsnummer:
**WO 99/48030 (23.09.1999 Gazette 1999/38)**

(54) **VERFAHREN UND VORRICHTUNG ZUR ERMITTLUNG EINER STÖRUNG EINES TECHNISCHEN SYSTEMS**

METHOD AND DEVICE FOR DETERMINING A FAULT IN A TECHNICAL SYSTEM

PROCEDE ET DISPOSITIF POUR DETERMINER UNE DEFAILLANCE D'UN SYSTEME TECHNIQUE

(84) Benannte Vertragsstaaten:
**DE FR GB**

(30) Priorität: **18.03.1998 DE 19811860**

(43) Veröffentlichungstag der Anmeldung:
**27.12.2000 Patentblatt 2000/52**

(73) Patentinhaber: **SIEMENS AKTIENGESELLSCHAFT
80333 München (DE)**

(72) Erfinder:
- **DENK, Georg
D-83026 Rosenheim (DE)**
- **SCHEIN, Oliver
D-63128 Dietzenbach (DE)**

(56) Entgegenhaltungen:
- **DENK G ET AL: "Adams methods for the efficient solution of stochastic differential equations with additive noise" COMPUTING, 1997, SPRINGER-VERLAG, AUSTRIA, Bd. 59, Nr. 2, Seiten 153-161, XP002111681 ISSN: 0010-485X**
- **DEMIR A ET AL: "TIME-DOMAIN NON-MONTE CARLO NOISE SIMULATION FOR NONLINEAR DYNAMIC CIRCUITS WITH ARBITRARY EXCITATIONS" IEEE/ACM INTERNATIONAL CONFERENCE ON COMPUTER-AIDED DESIGN. DIGEST TECHNICAL PAPERS (ICCAD), SAN JOSE, NOV. 6 - 10, 1994,6. November 1994 (1994-11-06), Seiten 598-603, XP000529874 INSTITUTE OF ELECTRICAL AND ELECTRONICS ENGINEERSISBN: 0-8186-6417-7 in der Anmeldung erwähnt**
- **MAMONTOV Y V ET AL: "Model for thermal noise in semiconductor bipolar transistors at low-current operation as multidimensional diffusion stochastic process" IEICE TRANSACTIONS ON ELECTRONICS, JULY 1997, INST. ELECTRON. INF. & COMMUN. ENG, JAPAN, Bd. E80-C, Nr. 7, Seiten 1025-1042, XP002111682 ISSN: 0916-8524**
- **SCHEIN O ET AL: "Numerical solution of stochastic differential-algebraic equations with applications to transient noise simulation of microelectronic circuits" JOURNAL OF COMPUTATIONAL AND APPLIED MATHEMATICS, 30 NOV. 1998, ELSEVIER, NETHERLANDS, Bd. 100, Nr. 1, Seiten 77-92, XP002111683 ISSN: 0377-0427**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 062 604 B1

## Beschreibung

Die numerische Simulation elektrischer Schaltungen hat in den letzten Jahren große Bedeutung bei der Entwicklung von Computerchips erlangt. Aufgrund der hohen Kosten für eine Musteranfertigung eines Chips und eines möglichen Redesigns sind Simulatoren unabdingbar geworden. Mit ihnen ist es möglich, prädiktive Aussagen über Betriebsverhalten und Effizienz der modellierten Schaltung an einem Rechner zu erhalten. Nach erfolgreichen Simulationsergebnissen wird üblicherweise ein Chip in Silizium gebrannt.

Unter Verwendung des sogenannten Netzwerkansatzes wird eine' Schaltung durch ihre topologischen Eigenschaften, die charakteristischen Gleichungen von Schaltelementen und die Kirchhoffschen Regeln beschrieben.

Zur Analyse einer Schaltung wird die aus [1] bekannte sogenannte modifizierte Knotenanalyse eingesetzt. Diese führt auf ein differential-algebraisches Gleichungssystem der Form

$$C(x(t)) \cdot \dot{x}(t) + f(x(t)) + s(t) = 0. \qquad (1)$$

Allgemein ist unter einem differential-algebraischen Gleichungssystem ein Gleichungssystem des Typs

$$F\left(\dot{x}(t), x(t), t\right) = 0 \qquad (2)$$

zu verstehen mit einer singulären Jacobi-Matrix $F_{\dot{x}}$ der partiellen Ableitungen von F nach $\dot{x}(t)$.

Das differential-algebraische Gleichungssystem (1) wird auch als quasilineares-implizites Gleichungssystem bezeichnet. Mit x(t) wird ein von einer Zeit t abhängiger Verlauf von Knotenspannungen bezeichnet, mit $\dot{x}(t)$ dessen Ableitung nach der Zeit t. Mit

$$f(x(t))$$

wird eine erste vorgegebene Funktion bezeichnet, welche Leitwerte und nicht-lineare Elemente enthält, mit

$$C(x(t))$$

eine vorgegebene Kapazitätsmatrix und mit s(t) eine zweite vorgegebene Funktion, die unabhängige Spannungsquellen und Stromquellen enthält.

Die Gleichung (1) beschreibt nur den Idealfall für eine Schaltung. In der Praxis läßt sich jedoch Rauschen, d.h. eine Störung der Schaltung, nicht vermeiden. Unter Rauschen versteht man eine ungewollte Signalstörung, die beispielsweise durch thermische Effekte oder die diskrete Struktur der Elementarladung verursacht wird. Aufgrund der fortschreitenden Integrationsdichte integrierter Schaltungen wächst die Bedeutung der prädiktiven Analyse solcher Effekte (Rauschsimulation).

Bei der Analyse einer Schaltung unter Berücksichtigung von Rauschen kann die Gleichung (1) nodelliert werden als:

$$C(x(t)) \cdot \dot{x}(t) + f(x(t)) + s(t) + B(t, x(t)) \cdot \nu(\omega, t) = 0. \qquad (3)$$

Hierbei bezeichnet $\nu(\omega, t)$ einen m-dimensionalen Vektor, dessen unabhängige Komponenten verallgemeinertes weißes Rauschen sind, wobei m die Zahl der Störstromquellen angibt. Eine auch als Intensitätsmatrix bezeich-

nete Matrix

$$B(t, x(t))$$

hat die Dimension n x m. Tritt nur thermisches Rauschen in linearen Widerständen auf, so ist sie konstant.

Wird die Schaltung mit rein linearen Elementen modelliert, so wird die Vorschrift (3) zu einem gestörten linear-impliziten differential-algebraischen Gleichungssystem der Form

$$C \cdot \dot{x}(t) + G \cdot x(t) + s(t) + B(t, x(t)) \cdot v(\omega, t) = 0 . \tag{4}$$

Unter dem Begriff Index ist im weiteren ein Maß zu verstehen, wie weit sich ein differential-algebraisches Gleichungssystem von einem expliziten gewöhnlichen Differentialgleichungssystem "unterscheidet", wie viele Ableitungsschritte erforderlich sind, um aus dem differential-algebraischen Gleichungssystem ein explizites gewöhnliches Differentialgleichungssystem zu erhalten.

Ohne Einschränkung der Allgemeingültigkeit und bei Existenz verschiedener Begriffsdefinitionen des Begriffs "Index", wird im weiteren folgende Definition für den Index eines differential-algebraischen Gleichungssystems verwendet:

Gegeben sei ein differential-algebraisches Gleichungssystem des Typs

$$F\left(\dot{x}(t), x(t), t\right) = 0 . \tag{2}$$

Existiert eine kleinste natürliche Zahl i, so daß die Gleichungen

$$F\left(\dot{x}(t), x(t), t\right) = 0 , \tag{5}$$

$$\frac{dF\left(\dot{x}(t), x(t), t\right)}{dt} = 0 , \tag{6}$$

$$\vdots ,$$

$$\frac{d^{(i)}F\left(\dot{x}(t), x(t), t\right)}{dt^{(i)}} = 0 \tag{7}$$

algebraisch in ein System expliziter gewöhnlicher Differentialgleichungen umgeformt werden können, so wird i als der Index des differential-algebraischen Gleichungssystems bezeichnet. Die Funktion F wird dabei als ausreichend oft differenzierbar vorausgesetzt.

Unter einem stochastischen Differentialgleichungssystem ist im weiteren allgemein folgendes Differentialgleichungssystem zu verstehen: Gegeben sei ein Wiener-Hopf-Prozeß

$$\left\{W_t;\, t \in \mathfrak{R}_0^+\right\}$$

auf einem Wahrscheinlichkeitsraum (Ω, A, P) zusammen mit seiner kanonischen Filtration $\{C_S; s \in [a,b]\}$. Seien ferner h und G:

$$[a, b] \times \mathfrak{R} \rightarrow \mathfrak{R} \text{ zwei } \left(\left(B_{[a,b]} \times B\right) - B\right)$$

-meßbare Zufallsvariablen
und $\tilde{X}: \Omega \rightarrow \mathfrak{R}$ eine ($C_a$ - B)-meßbare Funktion. Ein stochastisches Differentialgleichungssystem ist gegeben durch das Itö-Differential

$$X_S: \Omega \rightarrow \mathfrak{R},$$

$$\omega \mapsto \tilde{X}(\omega) + \int_{[a,s]} h\left(u, X_u(\omega)\right) d\lambda(u) + \left(\int_a^s G\left(u, X_u\right) dW_u\right)(\omega) \qquad (8)$$

oder symbolisch

$$dX_S = h\left(s, X_S\right) ds + G\left(s, X_S\right) dW_S, \qquad s \in [a, b]; \qquad X_a = \tilde{X}. \qquad (9)$$

Folgendes Verfahren zur Rauschsimulation ist aus [2] bekannt.

Die Vorschrift (4) kann für den Fall einer rein additiven Störung entkoppelt werden in einen differentiellen und einen algebraischen Teil.

Für den Fall einer rein additiven Störung gilt:

$$B\left(t, x(t)\right) \equiv B(t), \qquad (10)$$

d.h. die Intensitätsmatrix hängt nur von der Zeit t ab.

Damit wird (4) zu

$$C \cdot \dot{x}(t) + G \cdot x(t) + s(t) + B(t) \cdot \nu(\omega, t) = 0. \qquad (11)$$

Unter den Annahmen, daß konsistente Anfangswerte

$$\left(x_{det}\left(t_0\right), \dot{x}_{det}\left(t_0\right)\right)$$

zu einer Anfangszeit $t_0$ gegeben sind und bei Regularität des Matrixbüschels $\{\lambda C + G; \lambda \in C\}$, existiert eine eindeutige Lösung $x_{det}$ zu (1) in der Form

$$C \cdot \dot{x}_{det} + G \cdot x_{det} + s = 0. \qquad (12)$$

Ein Matrixbüschel $\{\lambda C + G; \lambda \in C\}$ ist regulär, falls ein $\lambda_0$ aus C existiert derart, daß gilt:

$$\det(\lambda_0 C + G) \neq 0. \qquad (13)$$

Konsistente Anfangswerte

$$\left(x_{det}(t_0), \dot{x}_{det}(t_0)\right)$$

können dadurch gewonnen werden, daß man einen DC-Arbeitspunkt des Systems, welches durch (12) beschrieben wird, bestimmt, also $x_{det} = 0$ setzt. Aus [3] ist ein weiteres Verfahren zur Ermittlung konsistenter Anfangswerte

$$\left(x_{det}(t_0), \dot{x}_{det}(t_0)\right)$$

bekannt.

Nach einer Transformation, die im folgenden beschrieben wird, gelangt man zu Vorschriften, die zur Vorschrift (11) äquivalent sind, der folgenden Form:

$$\dot{y}^{[1]} + F_1 \cdot y^{[1]} + F_2 \cdot y^{[2]} + \sigma^{[1]} + \left(\tilde{B}(t) \cdot v(\omega, t)\right)^{[1]} = 0 \qquad (14)$$

und

$$F_3 \cdot y^{[1]} + F_4 \cdot y^{[2]} + \sigma^{[2]} + \left(\tilde{B}(t) \cdot v(\omega, t)\right)^{[2]} = 0 \qquad (15)$$

mit transformierten Anfangsbedingungen

$$y^{[1]}{}_{det}(t_0) := \left(T^{-1} \cdot x_{det}(t_0)\right)^{[1]}, \qquad (16)$$

$$\dot{y}^{[1]}{}_{det}(t_0) := \left(T^{-1} \cdot \dot{x}_{det}(t_0)\right)^{[1]} \qquad (17)$$

und

$$y^{[2]}_{det}(t_0) := \left(T^{-1} \cdot x_{det}(t_0)\right)^{[2]}, \tag{18}$$

$$\dot{y}^{[2]}_{det}(t_0) := \left(T^{-1} \cdot \dot{x}_{det}(t_0)\right)^{[2]} \tag{19}$$

und mit

$$\tilde{B}(t) := S \cdot B(t). \tag{20}$$

Mit $F_i$, i = 1, 2, 3, 4, wird jeweils eine vorgebbare Matrix bezeichnet.

Die Transformation hat zum Ziel, die Vorschrift (11) in ein semi-explizites Differentialgleichungssystem des Typs der Vorschriften (14) und (15) in der Variable $y = (y^{[1]}, y^{[2]})^T$ mit geeigneten Matrizen $F_i$ und einer Funktion $\sigma = (\sigma^{[1]}, \sigma^{[2]})^T$ zu überführen.

Zur Matrix C aus (11) findet man dazu zwei reguläre Matrizen S und T derart, daß die Vorschrift

$$S \cdot C \cdot T = \text{blockdiag}(I, N) \tag{21}$$

erfüllt ist, wobei mit I eine Einheitsmatrix der Dimension r und mit N eine Nullmatrix der Dimension (n-r) bezeichnet wird.

Mittels Gauß Elimination mit vollständiger Pivotstrategie werden zwei reguläre Matrizen $P_1$ und $Q_1$ ermittelt mit

$$P_1 \cdot C \cdot Q_1 = C_1, \tag{22}$$

wobei eine Matrix $C_1$ eine rechte obere Dreicksmatrix ist, deren r erste Diagonalelemente ungleich dem Wert Null sind. Die Matrix $C_1$ hat ab der (r+1)-ten Zeile einschließlich nur Einträge mit dem Wert Null. Die Matrix $Q_1$ wird als orthogonale Spalten-Permutationsmatrix gewählt. Die Matrix $P_1$ ist das Produkt aus einer linken unteren Dreiecksmatrix und einer orthogonalen Zeilen-Permutationsmatrix.

Durch eine Multiplikation mit einer regulären rechten oberen Dreiecksmatrix $M_1$ von rechts werden alle Einträge der Matrix $C_1$ oberhalb ihrer Diagonalen eliminiert:

$$C_2 := C_1 \cdot M_1 = \text{diag}\left(\lambda_1, \ldots, \lambda_m, \underbrace{0, \ldots, 0}_{(n-r)-\text{mal}}\right). \tag{23}$$

Durch eine Multiplikation mit einer regulären Diagonalmatrix $M_2$ von links werden alle nichtverschwindenden Diagonalelemente der Matrix $C_2$ auf den Wert 1 transformiert:

$$C_3 := M_2 \cdot C_2 = \mathrm{diag}\left(\underbrace{1,\ldots,1}_{r-\mathrm{mal}},\ \underbrace{0,\ldots,0}_{(n-r)-\mathrm{mal}}\right). \qquad (24)$$

Die Matrizen S: = $M_2 \cdot P_1$ und T: = $Q_1 \cdot M_1$ leisten das Gewünschte.

Durch Setzen von y: = $T^{-1} \cdot x$, E: = $C_3 = S \cdot C \cdot T$, F: = $S \cdot G \cdot T$ und $\sigma = S \cdot s$ in Vorschrift (11) ergibt sich

$$E \cdot \dot{y} + F \cdot y + \sigma + \tilde{B} \cdot \nu = 0. \qquad (25)$$

Um die spezielle Struktur der Matrix $C_3$ auszunutzen, wird y in einen ersten Vektor $y^{[1]}$, der die ersten r Komponenten enthält, und in einen zweiten Vektor $y^{[2]}$, der die restlichen (n-r) Einträge enthält, unterteilt: $y = (y^{[1]}, y^{[2]})^T$.

Die Matrix F wird in 4 Untermatrizen $F_i$, i = 1, 2, 3, 4 der Dimensionen r x r, r x (n-r), (n-r) x r, (n-r) x (n-r) aufgeteilt:

$$F = \left(\begin{array}{c|c} F_1 & F_2 \\ \hline F_3 & F_4 \end{array}\right). \qquad (27)$$

Für die Matrix E wird eine entsprechende Aufteilung gewählt.

Die Matrix $E_1$ ist eine Einheitsmatrix der Dimension r x r und die Matrizen $E_2$,$E_3$ und $E_4$ sind Nullmatrizen. Somit zerfällt (25) in die beiden Vorschriften (14) und (15).

Ist die Matrix $F_4$ invertierbar, was genau dann der Fall ist, wenn das System aus Vorschrift (12) den Index 1 besitzt, so kann die Vorschrift (15),

$$F_3 \cdot y^{[1]} + F_4 \cdot y^{[2]} + \sigma^{[2]} + \left(\tilde{B}(t) \cdot \nu(\omega, t)\right)^{[2]} = 0 \qquad (15)$$

nach $y^{[2]}$ aufgelöst werden, was zu folgender Vorschrift führt:

$$y^{[2]} = -F_4^{-1} \cdot \left\{F_3 \cdot y^{[1]} + \sigma^{[2]} + \left(\tilde{B}(t) \cdot \nu(\omega, t)\right)^{[2]}\right\}. \qquad (28)$$

Im folgenden werden folgende abkürzende Bezeichnungen eingeführt:

$$\hat{F} := F_1 - F_2 \cdot F_4^{-1} \cdot F_3 ; \qquad (29)$$

$$\hat{s} := \sigma^{[1]} - F_2 \cdot F_4^{-1} \cdot \sigma^{[2]}; \qquad (30)$$

$$\hat{B}(t, x) := \left(I_r, -F_2 \cdot F_4^{-1}\right)^T \cdot \tilde{B}(t). \qquad (31)$$

Mit $I_r$ wird eine Einheitsmatrix der Dimension r, also des Rangs der Matrix C bezeichnet.

Durch Einsetzen von Vorschrift (28) in Vorschrift (14) ergibt sich:

$$\dot{y}^{[1]} + \hat{F} \cdot y^{[1]} + \hat{s} + \hat{B}(t) \cdot \nu(\omega, t) = 0. \tag{32}$$

Vorschrift (32) kann als ein stochastisches Differentialgleichungssystem interpretiert werden der folgenden Form:

$$dY_t^{[1]} = Y_{t_0}^{[1]} - \left\{\hat{F} \cdot Y_t^{[1]} + \hat{s}\right\}dt - \hat{B}(t)dW_t. \tag{33}$$

Mit $Y_{t_0}^{[1]}$ wird eine Zufallsvariable mit einem Erwartungswert $y_{det}^{[1]}$ $(t_0)$ bezeichnet, die eine endliche Varianz aufweist.

$$\left\{W_t; t \in \Re_0^+\right\}$$

ist ein Wiener-Hopf-Prozeß der Dimension der Anzahl der Rauschquellen, allgemein der Anzahl der Störquellen.

Das Verfahren aus [2] geht aus von Vorschrift (33), deren eindeutiger Lösungsprozeß $Y_t^{[1]}$ als Itô-Differential durch die Gleichung

$$Y_t^{[1]} = \Phi_{t,t_0} \cdot Y_{t_0}^{[1]} - \left( \int_{[t_0,t]} \Phi_{t,u} \cdot \hat{s}(u)d\lambda(u) + \int_{t_0}^{t} \Phi_{t,u} \cdot \hat{B}(u)dW_u \right) \tag{34}$$

mit dem Fundamentalsystem von Lösungen

$$\Phi_{t,t_0} = \exp\left( - \int_{[t_0,t]} \hat{F}d\lambda(u) \right) = \exp\left\{(t_0 - t)\hat{F}\right\} \tag{35}$$

gegeben ist.

Bei dem Verfahren aus [2] werden die Erwartungswerte $E_t$ und die zweiten Momente $P_t$ der Zufallsvariablen $Y_t^{[1]}$ näherungsweise bestimmt. Der Erwartungswert eines Itô-Integrals ist gleich dem Wert 0. Somit erhält man aus Vorschrift (34) direkt

$$E_t := E\left(Y_t^{[1]}\right) = \Phi_{t,t_0} \cdot y_{det}^{[1]}(t_0) - \int_{[t_0,t]} \Phi_{t,u} \cdot \hat{s}(u)d\lambda(u). \tag{35}$$

Für alle t löst $E_t$ das gewöhnliche Differentialgleichungssystem

$$\dot{x}_t + F \cdot x_t + \hat{s} = 0; \qquad x_{t_0} = y_{det}^{[1]}(t_0). \tag{36}$$

Die zweiten Momente

$$P_t = E\left\{\left(Y_t^{[1]}\right)^2\right\} \tag{37}$$

der Zufallsvariablen $Y_t^{[1]}$ des Lösungsprozesses genügen für alle t dem Differentialgleichungssystem

$$\frac{P_t}{dt} = -F \cdot P_t - P_t \cdot F^T - \hat{s} \cdot E_t^T - E_t \cdot \hat{s}^T + \hat{B}(t) \cdot \hat{B}(t)^T, \tag{38}$$

wobei eine Anfangsbedingung durch

$$P_{t_0} = E\left\{Y_{t_0}^{[1]} \cdot \left(Y_{t_0}^{[1]}\right)^T\right\} \tag{39}$$

gegeben ist. Bei (38) handelt es sich um ein lineares gewöhnliches Differentialgleichungssystem.

Parallel zur transienten Simulation der Schaltung werden bei dem Verfahren aus [2] durch numerische Integration mit linearen impliziten Mehrschrittverfahren näherungsweise die Erwartungswerte $E_t$ und die zweiten Momente $P_t$ ermittelt.

Ein Nachteil dieses Verfahrens ist darin zu sehen, daß zur Bestimmung der zweiten Momente $P_t$ für jeden Zeitschritt lineare Gleichungssysteme von quadratischer Ordnung in der Anzahl m der Rauschquellen gelöst werden.

Das Verfahren basiert auf einer manuellen Indexreduktion des differential-algebraischen Gleichungssystems auf ein explizites stochastisches Differentialgleichungssystem, die nicht automatisierbar ist. Außerdem wird nur ein Teil der Rauscheffekte betrachtet. Ferner liefert das Verfahren keine pfadweise Information, sondern nur die Momente der Knotenpotentiale, die bei der Indexreduktion erhalten bleiben. Für die Knotenpotentiale, die durch die Indexreduktion unterdrückt werden, liefert dieses Verfahren keine Information.

Ein weiterer Nachteil des Verfahrens aus [2] ist darin zu sehen, daß bei diesem Verfahren die Indexreduktion äußerst ineffizient sowie auch nicht automatisch durchführbar ist, insbesondere da die algebraischen Variablen in dem differential-algebraischen Gleichungssystem nicht berücksichtigt werden. Die Indexreduktion muß bei dem Verfahren aus [2] analytisch manuell durchgeführt werden, da die numerischen Verfahren nicht stabil sind.

Ferner ist es aus [4] bekannt, eine Rauschsimulation einer integrierten Schaltung im Frequenzbereich durchzuführen. Dadurch läßt sich eine Schaltung jedoch nur im Kleinsignalbereich analysieren. Die Voraussetzung eines festen Arbeitspunktes ist jedoch häufig nicht gegeben. Beispielsweise verhindert das Schwingverhalten eines Oszillators in einer Schaltung einen einheitlichen Arbeitpunkt.

In [5] ist eine Schaltungsbeschreibungssprache SPICE beschrieben, mit der eine elektrische Schaltung in einer für einen Rechner verarbeitbarer Form beschreibbar ist.

Aus [6] ist ein Verfahren zur numerischen Behandlung eines stochastischen Differentialgleichungssystems bekannt, die pfadweise Simulation diskreter Approximationen an den Lösungsprozeß, das als Runge-Kutta-Schema bezeichnet wird.

Aus [7] ist ein Simulator bekannt, der

- eine Initialisierungseinheit,
- eine Inkrementiereinheit,
- eine Einheit zur Aktualisierung eines Schätzwerts, und
- eine Ausgabeeinheit umfaßt. Von der Initialisierungseinheit wird ein Initialisierungswert eines Zustands und einer Funktion, mit denen ein System, welches einer zufälligen Störung unterliegt, beschrieben wird, der Inkrementiereinheit zugeführt. Die Inkrementiereinheit verwendet zwei Zufallszahlenfolgen um ein Inkrement des Schätzwerts zu bilden, ohne die Funktion selbst zu differenzieren. In der Einheit zur Aktualisierung eines Schätzwerts wird der Schätzwert um das Inkrement erhöht.

Weiterhin sind aus [8] ein Verfahren sowie eine Vorrichtung zur Verbesserung der Genauigkeit eines in einem geschlossenen Regelkreis geregelten Systems bekannt, wobei mindestens zwei stochastische Störsignale beerücksichtigt werden.

Somit liegt der Erfindung das Problem zugrunde, ein Verfahren anzugeben, mit dem die im vorigen beschriebenen Nachteile vermieden werden.

Das Problem wird durch das Verfahren gemäß Patentanspruch 1 und durch die Vorrichtung gemäß Patentanspruch 12 gelöst.

Bei dem Verfahren gemäß Anspruch 1 wird ein technisches System, welches einer Störung unterliegt, mittels eines impliziten stochastischen Differentialgleichungssystems (SDE) beschrieben. Eine näherungsweise Lösung des Systems wird ermittelt, indem ein diskreter Näherungsprozeß realisiert wird. Der diskrete Näherungsprozeß wird gemäß folgender Vorschrift realisiert:

$$\begin{aligned}(C + h\alpha_2 G) \cdot \tilde{X}_{\tau_{n+1}} = {} & \left\{-(1-\gamma)C + h(1+\gamma\alpha_1-\alpha_2)G\right\} \cdot \tilde{X}_{\tau_n} + \\ & + \left\{-\gamma C + h(\gamma - \alpha_1\gamma)G\right\} \cdot \tilde{X}_{\tau_{n-1}} + \\ & + h\alpha_2 s(\tau_{n+1}) + h(1+\gamma\alpha_1-\alpha_2)s(\tau_n) + \\ & + h(\gamma-\alpha_1\gamma)s(\tau_{n-1}) + \\ & + B(\tau_n) \cdot \Delta W_n + \gamma B(\tau_n) \cdot \Delta W_{n-1}\end{aligned}$$

wobei mit

- -- C eine erste Matrix,
- -- $\alpha_1$, $\alpha_2$, $\gamma$ vorgegebene Parameter aus dem Intervall [0, 1],
- -- $h:=\frac{T}{N}$, eine Schrittweite in einem Ausgangszeitintervall [0, T], wobei T ein vorgegebener Wert ist, welches in N Teilintervalle unterteilt ist,
- -- G eine zweite Matrix,
- -- $\tilde{x}_{\tau_{n+1}}$ eine Realisierung des Näherungsprozesses an einer Stützstelle $\tau_{n+1}$,
- -- $\tilde{x}_{\tau n}$ eine Realisierung des Näherungsprozesses an einer Stützstelle $\tau_n$,
- -- $\tilde{x}_{\tau_{n-1}}$ eine Realisierung des Näherungsprozesses an einer Stützstelle $\tau_{n-1}$,
- -- $s(\tau_{n+1})$ ein erster Wert an der Stützstelle $\tau_{n+1}$,
- -- $s(\tau_n)$ ein erster Wert an der Stützstelle $\tau_n$,
- -- $s(\tau_{n-1})$ ein erster Wert an der Stützstelle $\tau_{n-1}$,
- -- ein Differenzwert $\Delta W_{n-1}: = W_{\tau_n} - W_{\tau_{n-1}}$ zwischen einem zweiten Wert $W_{\tau_n}$ an der Stützstelle $\tau_n$ und dem zweiten Wert $W_{\tau_{n-1}}$ an der Stützstelle $\tau_{n-1}$
- -- $B(\tau_n)$ ein zweiter Wert an der Stützstelle $\tau_n$, bezeichnet wird, und

- bei dem durch iterative Lösung des Näherungsprozesses die Störung $\tilde{x}_{\tau_{n+1}}$ ermittelt wird.

Die Vorrichtung gemäß Patentanspruch 12 weist eine Prozessoreinheit auf, die derart eingerichtet ist, daß ein technisches System, welches einer Störung unterliegt, mittels eines impliziten stochastischen Differentialgleichungssystems beschrieben werden. Eine näherungsweise Lösung des Systems wird ermittelt, indem ein diskreter Näherungsprozeß realisiert wird. Der diskrete Näherungsprozeß wird gemäß folgender Vorschrift realisiert:

$$(C + h\alpha_2 G) \cdot \tilde{X}_{\tau_{n+1}} = \{-(1-\gamma)C + h(1 + \gamma\alpha_1 - \alpha_2)G\} \cdot \tilde{X}_{\tau_n} + \{-\gamma C + h(\gamma - \alpha_1\gamma)G\} \cdot \tilde{X}_{\tau_{n-1}} + h\alpha_2 s(\tau_{n+1}) + h(1 + \gamma\alpha_1 - \alpha_2)s(\tau_n) + h(\gamma - \alpha_1\gamma)s(\tau_{n-1}) + B(\tau_n) \cdot \Delta W_n + \gamma B(\tau_n) \cdot \Delta W_{n-1}$$

wobei mit

- -- C eine erste Matrix,
- -- $\alpha_1$, $\alpha_2$, $\gamma$ vorgegebene Parameter aus dem Intervall [0, 1],
- -- $h := \frac{T}{N}$, eine Schrittweite in einem Ausgangszeitintervall [0, T], wobei T ein vorgegebener Wert ist, welches in N Teilintervalle unterteilt ist,
- -- G eine zweite Matrix,
- -- $\tilde{X}_{\tau_{n+1}}$ eine Realisierung des Näherungsprozesses an einer Stützstelle $\tau_{n+1}$,
- -- $\tilde{X}_{\tau_n}$ eine Realisierung des Näherungsprozesses an einer Stützstelle $\tau_n$,
- -- $\tilde{X}_{\tau_{n-1}}$ eine Realisierung des Näherungsprozesses an einer Stützstelle $\tau_{n-1}$,
- -- $s(\tau_{n+1})$ ein erster Wert an der Stützstelle $\tau_{n+1}$,
- -- $s(\tau_n)$ ein erster Wert an der Stützstelle $\tau_n$,
- -- $s(\tau_{n-1})$ ein erster Wert an der Stützstelle $\tau_{n-1}$,
- -- ein Differenzwert $\triangle W_{n-1} := W_{\tau_n} - W_{\tau_{n-1}}$ zwischen einem zweiten Wert $W_{\tau_n}$ an der Stützstelle $\tau_n$ und dem zweiten Wert $W_{\tau_{n-1}}$ an der Stützstelle $\tau_{n-1}$
- -- $B(\tau_n)$ ein zweiter Wert an der Stützstelle $\tau_n$,

bezeichnet wird. Durch iterative Lösung des Näherungsprozesses wird die Störung $\tilde{X}_{\tau_{n+1}}$ ermittelt.

Die Erfindung verwendet direkt die implizite Struktur des technischen Systems, repräsentiert durch ein implizites Differentialgleichungssystem. Durch die Erfindung wird die Ermittlung der Störung erheblich beschleunigt, da die Dünnbesetztheit der Matrizen C und G ausgenutzt werden kann. Die numerisch instabile und aufwendige Transformation des Differentialgleichungssystems in die entkoppelte Form entfällt.

Durch die Erfindung ist es erstmals möglich, eine Störung auch bei einer singulären Matrix C zu ermitteln.

Vorteilhafte Weiterbildungen der Erfindung ergeben sich aus den abhängigen Ansprüchen.

Die Erfindung kann in verschiedensten Anwendungsgebieten eingesetzt werden, in denen ein technisches System gestört ist und durch ein System differential-algebraischer Gleichungen beschrieben werden kann.

Beispielsweise können Störungen (Rauschen) in einer elektrischen Schaltung ermittelt werden. Die Erfindung eignet sich ferner zur Anwendung in einem mechanischen Mehrkörpersystem oder in einem allgemeinen physikalischen System, einem chemischen System oder auch einem physikalisch-chemischen System, deren jeweilige Modellierung auf ein System differential-algebraischer Gleichungen führt.

Ohne Einschränkung der Allgemeingültigkeit wird im weiteren die Erfindung anhand eines Ausführungsbeispiels einer Rauschsimulation einer elektrischen Schaltung beschrieben, das in den Figuren dargestellt ist.

Es zeigen

Figur 1 ein Ablaufdiagramm, in dem die einzelnen Verfahrensschritte dargestellt sind;
Figur 2 eine Vorrichtung, mit der das Verfahren durchgeführt wird;
Figur 3 eine Skizze einer elektrischen Schaltung eines Differentiators;
Figur 4 eine Darstellung eines Simulationsergebnisses.

In Figur 2 ist in Form einer Blockskizze ein Rechner R dargestellt, mit dem das im weiteren beschriebene Verfahren durchgeführt wird. Der Rechner R weist eine Prozessoreinheit P auf, die derart eingerichtet ist, daß die im weiteren beschriebenen Verfahrensschritte durchgeführt werden können. Die Prozessoreinheit P ist über einen Bus B mit einem Speicher SP verbunden. Der Rechner R ist über eine erste Schnittstelle I/O 1 mit einer Tastatur TA und über eine zweite Schnittstelle I/O 2 mit einer Maus MA verbunden, mit denen jeweils ein Benutzer des Rechners R Eingaben vornehmen kann. Ferner ist der Rechner R mit einem Bildschirm BS verbunden, auf dem dem Benutzer Ergebnisse des Verfahrens dargestellt werden.

In dem Speicher SP ist die zu analysierende Schaltung S (vgl. Figur 3) in Form einer Schaltungsbeschreibungssprache gespeichert. Als Schaltungsbeschreibungssprache wird das Netzlistenformat von SPICE eingesetzt.

Ein Ersatzschaltbild der Schaltung S für dieses Ausführungsbeispiel ist in Figur 3 dargestellt. Die Schaltung S stellt in ihrer Funktionalität einen Differentiator dar. Eine unabhängige Spannungsquelle V(t) ist zwischen einem ersten Knoten $N_1$ und einem Massepotential $N_0$ angeordnet. Zwischen dem ersten Knoten $N_1$ und einem zweiten Knoten $N_2$ ist eine Kapazität $C_0$ vorgesehen. Der zweite Knoten $N_2$ ist über einen Widerstand R mit einem dritten Knoten $N_3$ verbunden. Ferner ist zur Modellierung eines thermischen Rauschens in dem Widerstand R eine zu dem Widerstand R parallel geschaltete Rauschstromquelle RS mit der Stromstärke $\Delta I_R$ vorgesehen. Ein erster Eingang E1 eines Operationsverstärkers OV ist mit dem zweiten Knoten $N_2$ verbunden, ein zweiter Eingang E2 des Operationsverstärkers OV mit dem Massepotential $N_0$. Ein Ausgang A des Operationsverstärkers OV ist mit dem dritten Knoten $N_3$ verbunden.

Die Schaltung S wird in einem ersten Schritt 101 in Form des Netzlistenformats von SPICE in dem Speicher SP gespeichert (vgl. Figur 1).

In einem zweiten Schritt 102 wird für die Schaltung S eine modifizierte Knotenanalyse durchgeführt. Das Ergebnis der modifizierten Knotenanalyse ist das der Schaltung S zugehörige Gleichungssystem.

In Matrixschreibweise ergibt sich für die Schaltung S das linear-implizite Differentialgleichungssystem des Indexes 1 mit rein additiver Störung

$$\begin{pmatrix} C_0 & -C_0 & 0 & 0 & 0 \\ -C_0 & C_0 & 0 & 0 & 0 \\ 0 & 0 & 0 & 0 & 0 \\ 0 & 0 & 0 & 0 & 0 \\ 0 & 0 & 0 & 0 & 0 \end{pmatrix} \cdot \begin{pmatrix} \dot{u}_1 \\ \dot{u}_2 \\ \dot{u}_3 \\ \dot{I}_Q \\ \dot{I}_{ampl} \end{pmatrix} +$$

$$+ \begin{pmatrix} 0 & 0 & 0 & 1 & 0 \\ 0 & \frac{1}{R} & -\frac{1}{R} & 0 & 0 \\ 0 & -\frac{1}{R} & \frac{1}{R} & 0 & -1 \\ 0 & A & 1 & 0 & 0 \\ 1 & 0 & 0 & 0 & 0 \end{pmatrix} \cdot \begin{pmatrix} u_1 \\ u_2 \\ u_3 \\ I_Q \\ I_{ampl} \end{pmatrix} + + \begin{pmatrix} 0 \\ \sqrt{\frac{4kT}{R}\Delta f} \\ -\sqrt{\frac{4kT}{R}\Delta f} \\ 0 \\ 0 \end{pmatrix} \cdot v(t, \omega) = \begin{pmatrix} 0 \\ 0 \\ 0 \\ 0 \\ V(t) \end{pmatrix}$$

Es werden mit

- $u_1$, $u_2$, $u_3$ die Spannungen an den Knoten $N_1$,$N_2$,$N_3$,
- $I_Q$ der durch den ersten Knoten $N_1$ und durch die Spannungsquelle V(t) fließende Strom,
- $I_{ampl}$ der durch den dritten Knoten $N_3$ und den Operationsverstärker OV fließende Strom,
- R der Wert des Widerstand R,
- $C_0$ der Wert der Kapazität $C_0$,
- A ein Verstärkungsfaktor des Operationsverstärkers OV, bezeichnet.

In dem Modell des thermischen Rauschens ist die Stromstärke $\Delta I_R$ des Stroms, der durch die Rauschstromquelle RS fließt, durch die Gleichung

$$\Delta I_R = \sqrt{\frac{4kT}{R}\Delta f} \cdot \nu(\omega, t) \quad (40)$$

angenommen.

Hierbei beschreibt $\nu(\omega,t)$ als weißes Rauschen den treibenden verallgemeinerten stochastischen Prozeß, also die Störung des technischen Systems. Die Größen k, T und $\Delta f$ sind als Konstanten vorgegeben.

Allgemein ergibt sich also ein nichtentkoppeltes linearimplizites Differentialgleichungssystem mit rein additiver stochastischen Störung (Rauschen) der folgenden Form:

$$C \cdot \dot{x}(t) + G \cdot x(t) + s(t) + B(t) \cdot \nu(\omega, t) = 0. \quad (41)$$

Zur Herleitung des Verfahrens, nicht aber für das Verfahren selbst, wird angenommen , daß die Kapazitätsmatrix C invertierbar ist.

Durch Multiplikation der Gleichung (41) mit der inversen Kapazitätsmatrix $C^{-1}$ erhält man

$$\dot{x}(t) = -C^{-1} \cdot \{G \cdot x(t) + s(t)\} - C^{-1} \cdot B(t, x(t)) \cdot \nu(\omega, t). \quad (42)$$

Die Vorschrift (42) wird als stochastisches Differentialgleichungssystem der Form

$$dX_t = X_{t_0} - C^{-1} \cdot \{G \cdot X_t + s\}dt - C^{-1} \cdot B(t)dW_t \quad (43)$$

interpretiert, wobei $X_{t_0}$ eine Zufallsvariable mit Erwartungswert $x_{det}(t_0)$bezeichnet.

Auf das Differentialgleichungssystem (37) wird folgendes Verfahren, das in [6] beschrieben ist, angewendet (Das Verfahren wird als implizites starkes Zweischrittverfahren der Ordnung 1 für ein stochastisches Differentialgleichungssystem bezeichnet) :

Ein numerisches Verfahren liefert für jede natürliche Zahl N Realisierungen eines diskreten Näherungsprozesses

$$\{\tilde{X}_s; s = \tau_0, \ldots, \tau_n\},$$

indem es für gegebene $\omega$ aus $\Omega$ an den jeweiligen Stützstellen $\tau_i$ Approximationen

$$\tilde{X}(\omega, \tau_i)$$

für die Werte $X(\omega, \tau_i)$berechnet.

Um einen stetigen Näherungsprozeß

$$\{\tilde{X}_s; s \in [0, T]\}$$

zu erhalten, interpoliert man die erhaltenen Werte z.B. stückweise linear. Die sich ergebenden Pfade können anschließend mit statistischen Methoden analysiert werden.

In [6] ist folgende Familie von impliziten starken Zweischrittverfahren der Ordnung 1 zur Bestimmung der Komponente k der Realisierungen $\{\tilde{X}_{\tau i}; i = 0, \ldots, N\}$ angegeben:

$$\tilde{X}_{n+1}^{k} = \left(1 - \gamma_k\right)\tilde{X}_n^k + \gamma_k \tilde{X}_{\tau_{n-1}}^k + h\left\{\begin{aligned}&\alpha_{2,k} f^k\left(\tau_{n+1}, \tilde{X}_{\tau_{n+1}}\right) + \left(1 + \gamma_k \alpha_{1,k} - \alpha_{2,k}\right) f^k \\ &+ \gamma_k\left(1 - \alpha_{1,k}\right) f^k\left(\tau_{n-1}, \tilde{X}_{\tau_{n-1}}\right)\end{aligned}\right\} + V_n^k + \gamma_k V_{n-1}^k \quad (44)$$

Hierbei steht eine Funktion ohne Argumente für eine Auswertung am Punkt

$$\left(\tau_n, \tilde{X}_{\tau_n}\right).$$

Die reellen Parameter $\alpha_{1,k}$, $\alpha_{2,k}$ und $\gamma k$ sind aus dem Intervall [0, 1] gewählt. Ferner ist die Größe $V_n^k$ gegeben durch

$$V_n^k = \sum_{j=1}^{m} g^{k,j} \Delta W_n^j + \sum_{j_1, j_2}^{m} L^{j_1} g^{k,j_2} I_{(j_1, j_2), \tau_n, \tau_{n+1}}, \quad (45)$$

wobei

$$\Delta W_n := W_{\tau_{n+1}} - W_{\tau_n} \quad (46)$$

die Zuwächse des Wiener-Prozesses beschreibt und $L^j$ eine abkürzende Schreibweise für den Operator

$$L^j := \sum_{k=1}^{d} g^{k,j} \frac{\partial}{\partial x^k}, \qquad j = 1, \ldots, m \quad (47)$$

ist.

Die Größe $I_{(j_1,j_2), \tau_n, \tau_{n+1}}$ beschreibt das mehrfache Itô-Integral

$$I_{(j_1, j_2), \tau_n, \tau_{n+1}} := \int_{\tau_n}^{\tau_{n+1}} \int_{\tau_n}^{s_2} dW_{s_1}^{j_1} dW_{s_2}^{j_2}. \quad (48)$$

h ist gegeben durch die Vorschrift

$$h := \frac{T}{N}. \quad (49)$$

Wählt man für alle k = 1, ... , n die Parameter $\alpha_{1,k}$, $\alpha_{2,k}$ und $\gamma k$, so vereinfacht sich Vorschrift (44) für den Fall rein additiver Störung in Vektorschreibweise zu

$$\tilde{X}^{k}_{n+1} = (1-\gamma)\tilde{X}_n + \gamma\tilde{X}_{\tau_{n-1}}$$
$$+h\left\{\alpha_2 f\left(\tau_{n+1}, \tilde{X}_{\tau_{n+1}}\right) + (1+\gamma\alpha_1-\alpha_2)f + \gamma(1-\alpha_1)f\left(\tau_{n-1}, \tilde{X}_{\tau_{n-1}}\right)\right\},$$
$$+g\cdot\Delta W_n + \gamma g\cdot\Delta W_{n-1}$$

da die Funktion g nur von der Zeit abhängt. Vorschrift (50) wird auf das Differentialgleichungssystem (43) angewendet.

Es ergibt sich somit:

$$\tilde{X}_{\tau_{n+1}} = (1-\gamma)\tilde{X}_{\tau_n} + \gamma\tilde{X}_{\tau_{n-1}} -h\left\{\begin{array}{l}\alpha_2 C^{-1}\left(G\cdot\tilde{X}_{\tau_{n+1}} + s(\tau_{n+1})\right) + \\ +(1+\gamma\alpha_1-\alpha_2)C^{-1}\left(G\cdot\tilde{X}_{\tau_n} + s(\tau_n)\right) \\ +(\gamma-\alpha_1\gamma)C^{-1}\left(G\cdot\tilde{X}_{\tau_{n-1}} + s(\tau_{n-1})\right)\end{array}\right\} -C^{-1}B(\tau_n)\Delta W_n - \gamma C^{-1}B(\tau_n)\Delta W_{n-1} \quad (51)$$

Im nächsten Schritt wird (40) mit -C multipliziert.

Es ergibt sich somit:

$$-C\left\{\tilde{X}_{\tau_{n+1}} - (1-\gamma)\tilde{X}_{\tau_n} - \gamma\tilde{X}_{\tau_{n-1}}\right\} = h\left[\begin{array}{l}\alpha_2\left\{G\cdot\tilde{X}_{\tau_{n+1}} + s(\tau_{n+1})\right\} \\ +(1+\gamma\alpha_1-\alpha_2)\left\{G\cdot\tilde{X}_{\tau_n} + s(\tau_n)\right\} \\ +(\gamma-\alpha_1\gamma)\left\{G\cdot\tilde{X}_{\tau_{n-1}} + s(\tau_{n-1})\right\}\end{array}\right], +B(\tau_n)\cdot\Delta W_n + \gamma B(\tau_n)\cdot\Delta W_{n-1} \quad (52)$$

Durch Zusammenfassen der Terme in $\tilde{X}_{\tau n+1}$ auf der rechten Seite von (41) ergibt sich:

$$-\left(C + h\alpha_2 G\right) \cdot \tilde{X}_{\tau_{n+1}} = \left\{-\left(1-\gamma\right)C + h\left(1+\gamma\alpha_1-\alpha_2\right)G\right\} \cdot \tilde{X}_{\tau_n} + \\ +\left\{-\gamma C + h\left(\gamma - \alpha_1\gamma\right)G\right\} \cdot \tilde{X}_{\tau_{n-1}} + \\ +h\alpha_2 s\left(\tau_{n+1}\right) + h\left(1+\gamma\alpha_1-\alpha_2\right)s\left(\tau_n\right) + \\ +h\left(\gamma-\alpha_1\gamma\right)s\left(\tau_{n-1}\right) + \\ +B\left(\tau_n\right) \cdot \Delta W_n + \gamma B\left(\tau_n\right) \cdot \Delta W_{n-1} \qquad (53)$$

Für den Fall des Indexes 0 ist durch Vorschrift (53) eine Vorschrift angegeben, mit der die Störung des Systems ermittelt werden kann. Vorschrift (53) kann auch im Fall des Indexes 1 angewendet werden.

Durch iterative Lösung des Näherungsprozesses wird in einem weiteren Schritt 103 die Störung $\tilde{X}\tau_{n+1}$ ermittelt. Die Bestimmung der Störung $\tilde{X}\tau_{n+1}$ wird iterativ in einer Schleife für n = 0,1, ... , N - 1 durchgeführt, wodurch der Verlauf der Störung $\tilde{X}\tau_{n+1}$ zu den jeweiligen Zeitpunkten $\tau_n$ ermittelt wird.

Abhängig von der ermittelten Störung wird eine Schaltung S modifiziert, so daß die vorgebbaren Bedingungen z.B. hinsichtlich der Störanfälligkeit der Schaltung S erfüllt sind.

Die modifizierte Schaltung wird in einem letzten Schritt in Silizium gebrannt.

Figur 4 zeigt als Ergebnis des von dem Rechner R durchgeführten Verfahrens, das im weiteren als Programm angegeben ist. Es ist dargestellt ein numerisch simulierter Lösungspfad RLP des Spannungsverlaufs im dritten Knoten $N_3$ unter Berücksichtigung des Rauschens. Ferner ist zum Vergleich der ideale Lösungspfad ILP, d.h. der Lösungspfad ohne Berücksichtigung des Rauschens angegeben. Außerdem ist der der Verlauf V der Eingangsgröße V(t) dargestellt.

Für das Verfahren wurden folgende Parameter verwendet:

$$\Delta = 2{,}5 \cdot 10^{-11} \qquad [s]$$

$$V(t) = \begin{cases} 0 \quad \text{für } 0 \le t \le 5 \cdot 10^{-9} \\ 2 \cdot 10^{6} \cdot t - 1 \cdot 10^{-2} \quad \text{für } 5 \cdot 10^{-9} < t \le 10 \cdot 10^{-9} \\ 1 \cdot 10^{-2} \quad \text{für } 10 \cdot 10^{-9} < t \le 15 \cdot 10^{-9} \\ -2 \cdot 10^{6} \cdot t + 4 \cdot 10^{-2} \quad \text{für } 15 \cdot 10^{-9} < t \le 20 \cdot 10^{-9} \\ 0 \quad \text{für } 20 \cdot 10^{-9} < t \le 25 \cdot 10^{-9} \end{cases} \qquad [V]$$

$$C_0 = 1 \cdot 10^{-12} \qquad [F]$$

$$R = 1 \cdot 10^{4} \qquad [\Omega]$$

$$\Delta f = 1 \qquad [Hz]$$

Im weiteren sind einige Varianten bzw. Verallgemeinerungen des oben beschriebenen Ausführungsbeispiels dargestellt:

Die Kapazitätsmatrix kann ohne weiteres auch singulär sein. Somit ist es erstmals möglich, auch eine singuläre Kapazitätsmatrix zu berücksichtigen.

Ferner können auch weitere in [6] beschriebene Verfahren zur pfadweisen Approximation eines stochastischen Differentialgleichungssystems eingesetzt werden, um z.B. eine höhere Konvergenzordnung zu erreichen.

Die Erfindung ist keineswegs auf die Ermittlung thermischen Rauschens beschränkt. Im Gegenteil kann jedes Modell einer Störung im Rahmen der Erfindung berücksichtigt werden, welches durch weißes Rauschen beschrieben oder approximiert werden kann, z.B. das Schrotrauschen in Stromquellen. Bei Berücksichtigung des Schrotrauschens wird die Stromquelle modelliert durch eine parallel geschaltete, zufallsabhängige Stromquelle, deren Stromstärke $\Delta I_Q$ der Vorschrift

$$\Delta I_Q = \sqrt{2eI_{det}\Delta f} \cdot \nu(\omega, t)$$

genügt.

Im weiteren ist eine Realisierung des Verfahrens zur Rauschsimulation in der Programmiersprache FORTRAN77 angegeben.

```
PROGRAM integr
C
C Verfahren zur numerischen Loesung linear-impliziter
C Differentialgleichungssysteme mit rein additiver Störung.
C
      IMPLICIT NONE
      INTRINSIC dble, real
      EXTERNAL setall, gennor, dgesv, giveB, gives
      EXTERNAL a_smsm, m_mv, v_to_v, m_sv, a_vvvv
      REAL gennor
C
C Konstanten- und Variablendeklarationen und Initialisierung
C
      INTEGER n, m,  anz, i, j, info, init1, init2
C
C n ist die Dimension des Systems, m die Anzahl der
C Rauschquellen
C anz ist die Anzahl der betrachteten Teilintervalle,
C i und j sind Hilfsvariablen für Schleifen,
C info fragt den Return-Code
C init1 und init2 sind die Samen fuer den
C Pseudozufallszahlengenerator
C
      PARAMETER (n = 5, m = 1, anz = 1000)
      PARAMETER (init1 = 23556, init2 = 4285979)
C
      DOUBLE PRECISION lrand, rrand, h, tauakt, alpha
C
C [lrand, rrand] bezeichnet das betrachtete Intervall
C h die Schrittweite, tauakt den aktuellen Zeitpunkt,
C alpha den Parameterwert alpha2 aus (53), wobei alpha1 = 0.0
C und gamma = 0.0 gesetzt wurde.
C
      PARAMETER(alpha = 0.9)
```

```
      PARAMETER (lrand = 0.0d0, rrand = 2.5d-8)
C
      DOUBLE PRECISION xakt(n), d(n), salt(n), sakt(n)
      DOUBLE PRECISION C(n,n), G(n,n), B(n,m), A(n,n)
      DOUBLE PRECISION h1_n(n),  h2_n(n), h3_n(n), h4_n(n)
      DOUBLE PRECISION h1_m(m), h1_nn(n, n)
C
C xakt beschreibt den Wert des Lösungsprozesses am Zeitpunkt
C tauakt,
C C, B und G sind die Matrizen des Problems der Vorschrift
C (3)
C A und d dienen zum Gleichungsaufbau
C salt und sakt beschreiben s(taukt) bzw. s(takt - 1)
C h*_* bezeichnen Hilfsvektoren und -matrizen
C
C Konsistenten Anfangsvektor setzen
      xakt(1) = 0.0d0
      xakt(2) = 0.0d0
      xakt(3) = 0.0d0
      xakt(4) = 0.0d0
      xakt(5) = 0.0d0
C
C Definition der Matrix C (mit Kapazität = 1* 10^{-12}
C Farad)
      C(1,1) =  1.0d-12
      C(2,1) =  -1.0d-12
      C(3,1) =  0.0d0
      C(4,1) =  0.0d0
      C(5,1) = 0.0d0
      C(1,2) =  -1.0d-12
      C(2,2) =  1.0d-12
      C(3,2) =  0.0d0
      C(4,2) =  0.0d0
      C(5,2) = 0.0d0
      C(1,3) =  0.0d0
      C(2,3) =  0.0d0
      C(3,3) =  0.0d0
```

```
      C(4,3) =  0.0d0
      C(5,3) = 0.0d0
      C(1,4) =  0.0d0
      C(2,4) =  0.0d0
      C(3,4) =  0.0d0
      C(4,4) =  0.0d0
      C(5,4) = 0.0d0
      C(1,5) = 0.0d0
      C(2,5) = 0.0d0
      C(3,5) = 0.0d0
      C(4,5) = 0.0d0
      C(5,5) = 0.0d0
C
C Definition der Matrix G (mit R1 = 10000, A = 300})
      G(1,1) =  0.0d0
      G(2,1) =  0.0d0
      G(3,1) =  0.0d0
      G(4,1) =  0.0d0
      G(5,1) =  1.0d0
      G(1,2) =  0.0d0
      G(2,2) =  1.0d-4
      G(3,2) =  -1.0d-4
      G(4,2) =  3.0d2
      G(5,2) =  0.0d0
      G(1,3) =  0.0d0
      G(2,3) =  -1.0d-4
      G(3,3) =  1.0d-4
      G(4,3) =  1.0d0
      G(5,3) =  0.0d0
      G(1,4) =  1.0d0
      G(2,4) =  0.0d0
      G(3,4) =  0.0d0
      G(4,4) =  0.0d0
      G(5,4) =  0.0d0
      G(1,5) =  0.0d0
      G(2,5) =  0.0d0
      G(3,5) =  -1.0d0
```

```
      G(4,5) =  0.0d0
      G(5,5) =  0.0d0
C
C Pseudozufallszahlengenerator initialisieren
      CALL setall(init1, init2)
C
C Schrittweite berechnen
C
      h = (rrand - lrand) / anz
C
C Zeitpunkt und x-Wert initialisieren
C
      tauakt = lrand
C
C Ausgabedatei öffnen
      OPEN(9, FILE = 'opmit1000', FORM = 'FORMATTED')
C Anfangszeitpunkt und -wert in die Ausgabedatei schreiben
      WRITE(9, 42) tauakt, (xakt(i), i = 1, n)
C "alten" s-Wert merken
      CALL gives(salt, n, tauakt)
C
C Äussere Schleife: Entspricht der Behandlung eines
C Teilintervalls
      DO 10, i = 1, anz
C Aufbauen des Systems A*X=b
C
C Aufbauen von A
C A = -C -alpha * h * G
         CALL a_smsm(C, G, -1.0d0, -alpha * h, A, n, n)
C B aufbauen
         CALL giveB(B, n, m, tauakt)
C Zeitpunkt erhöhen
         tauakt = tauakt + h
C sakt aufbauen -- salt liegt vor Schleifeneintritt vor
         CALL gives(sakt, n, tauakt)
C "alten" s-Wert merken
         CALL v_to_v(sakt, salt, n)
```

```
C d aufbauen
C
C h1_nn = -C + (1- alpha) * h * G
          CALL a_smsm(C, G, -1.0d0, (1-alpha)* h, h1_nn, n, n)
C h1_n = h11_nn * xakt
          CALL m_mv(h1_nn, xakt, h1_n, n, n)
C h2_n = alpha * h * sakt
          CALL m_sv(sakt, alpha*h, h2_n, n)
C h3_n = (1 - alpha) * h * salt
          CALL m_sv(salt, (1- alpha) * h, h3_n, n)
C h1_m = DeltaW
          DO 20, j = 1, m
             h1_m(j) = DBLE(gennor(0.0, SQRT(REAL(h))))
 20       CONTINUE
C h4_n = B * h1_m
          CALL m_mv(B, h1_m, h4_n, n, m)
C d = h1_n + h2_n + h3_n + h4_n
          CALL a_vvvv(h1_n, h2_n, h3_n, h4_n, d, n)
C Aufrufen des Gleichungsl"osers (h1_n ist nur Dummy)
          CALL dgesv(n, 1, A, n, h1_n, d, n, info)
C Neuen Wert von xakt setzen
          CALL v_to_v(d, xakt, n)
C aktuellen Zeitpunkt und x-Wert in die Ausgabedatei schrei
C ben
          WRITE(9, 42) tauakt, (xakt(j), j = 1, 3)
 42       FORMAT(E16.6,E16.6,E16.6,E16.6,E16.6, E16.6)
 10   CONTINUE
C
C Ausgabedatei schliessen
      CLOSE(9, STATUS = 'keep')
      STOP
      END
C
C============================================================
C
      SUBROUTINE giveB(outB, n, m, tauakt)
C
```

```
C Liefert in outB den Wert der (n x m)-Matrix B
C aus Vorschrift (3) zum Zeitpunkt tauakt
C
      IMPLICIT NONE
      INTRINSIC dsqrt
C
C Dummy Argumente
      INTEGER n,m
      DOUBLE PRECISION outB(n, m), tauakt

C Lokale Variable
      DOUBLE PRECISION k, T, deltaf
C k bezeichnet die Boltzmann-Konstante, T die absolute
C Temperatur, deltaf die Rauschbandbreite
      PARAMETER(k = 1.308d-23, T = 300, deltaf = 1.0d0)
C Zeitunabhängige Definition der Matrix B aus Beispiel 3.4
C (mit R1 = 3000, R2 = 4000, R3 = 5000 Ohm
C T = 300 K, k = 1.3807 * 10^{-23} jK ^{-1}, f = 10)
C
      outB(1,1) = 0.0d0
      outB(2,1) = dsqrt(4*k*T*deltaf/10000.0d0)
      outB(3,1) = -dsqrt(4*k*T*deltaf/10000.0d0)
      outB(4,1) = 0.0d0
      outB(5,1) = 0.0d0
      RETURN
      END
C
C==============================================================
C
      SUBROUTINE gives(outs, n, tauakt)
C
C Liefert in outs den Wert des (n)-Vektors s
C aus Vorschrift (3) zum Zeitpunkt tauakt
C
C
      IMPLICIT NONE
      INTRINSIC sin
```

```
C
C Dummy Argumente
      INTEGER n
      DOUBLE PRECISION outs(n), tauakt
C
C Lokale Variable
      INTEGER i
C i beschreibt die aktuelle Zeilenposition von outs
      DO 10, i = 1, n - 1
         outs(i) = 0.0d0
 10   CONTINUE
      IF (0.0d0 .le. tauakt .and. tauakt .le. 5.0d-9) THEN
         outs(n) = 0.0d0
    ELSE IF    (5.0d-9 .lt. tauakt .and. tauakt .le. 10.0d-9)
     THEN
         outs(n) = -(2.0d6 * tauakt - 1.0d-2)
     ELSE IF  (10.0d-9 .lt. tauakt .and. tauakt .le. 15.0d-9)
     THEN
         outs(n) = -(10.0d-3)
     ELSE IF  (15.0d-9 .lt. tauakt .and. tauakt .le. 20.0d-9)
     THEN
         outs(n) = -(-2.0d6 * tauakt + 4.0d-2)
     ELSE IF  (20.0d-9 .lt. tauakt .and. tauakt .le. 25.0d-9)
     THEN
         outs(n) = 0.0d0
      END IF
      RETURN
      END
```

Im Rahmen dieses Dokuments wurden folgende Veröffentlichungen zitiert:

[1] A. F. Schwarz, Computer-Aided design of microelectronic circuits and systems, vol. 1, Academic Press, London, ISBN 0-12-632431-X, S. 185 - 188, 1987

[2] A. Demir et al, Time-domain non-Monte Carlo noise simulation for nonlinear dynamic circuits with arbitrary excitations, IEEE Transactions on Computer-Aided Design of Integrated Circuits and Systems, Vol. 15, No. 5, S. 493 - 505, May 1996

[3] B.J. Leimkuhler et al, Approximation methods for the consistent initialization of differential-algebraic systems of equations, SIAM J. Numer. Anal., Vol. 28, S. 205 - 226, 1991

[4] L. O. Chua und P. M. Lin, Computer aided design of electronic circuits, Prentice Hall, Englewood Cliffs, 1975, ISBN 0-13-165415-2, S. 596

[5] W. Nagel, SPICE2 - a computer program to simulate semiconductor circuits, Tech. Report, UC Berkeley, Memo ERL-M 520, 1975

[6] P.E. Kloeden und E. Platen, Numerical solution of stochastic differential equations, Springer Verlag, Berlin, New York, ISBN 3-540-54062-8, S. 412, 1992

[7] US 5 646 869

[8] US 5 132 897

## Patentansprüche

**1.** Verfahren zur Ermittlung einer Störung eines technischen Systems, welches der Störung unterliegt,

- bei dem das System mittels eines impliziten stochastischen Differentialgleichungssystems beschrieben wird, welches folgende Form aufweist:

$$C * \dot{x}(t) + G * x(t) + s(t) + B * v(t) = 0,$$

wobei mit C eine erste Matrix, mit x(t) eine Ableitung eines Zustands des Systems nach einer Zeit, welche durch eine Zeitvariable t beschrieben wird, mit G eine zweite Matrix, mit s(t) eine Systemfunktion von unabhängigen Systemgrößen, mit B eine dritte Matrix und mit v(t) eine Störfunktion bezeichnet wird,

- bei dem eine näherungsweise Lösung des impliziten stochastischen Differentialgleichungssystems ermittelt wird, indem ein diskreter Näherungsprozeß realisiert wird,
- **dadurch gekennzeichnet daß** der diskrete Näherungsprozeß gemäß folgender Vorschrift (103) realisiert wird:

$$\begin{aligned}(C + h\alpha_2 G) \cdot \tilde{X}_{\tau_{n+1}} = {} & \left\{-(1-\gamma)C + h(1 + \gamma\alpha_1 - \alpha_2)G\right\} \cdot \tilde{X}_{\tau_n} + \\ & + \left\{-\gamma C + h(\gamma - \alpha_1\gamma)G\right\} \cdot \tilde{X}_{\tau_{n-1}} + \\ & + h\alpha_2 s(\tau_{n+1}) + h(1 + \gamma\alpha_1 - \alpha_2)s(\tau_n) + \\ & + h(\gamma - \alpha_1\gamma)s(\tau_{n-1}) + \\ & + B(\tau_n) \cdot \Delta W_n + \gamma B(\tau_n) \cdot \Delta W_{n-1}\end{aligned}$$

wobei mit

-- $\alpha_1$, $\alpha_2$, $\gamma$ vorgegebene Parameter aus dem Intervall [0, 1],
-- $h := \frac{T}{N}$, eine Schrittweite in einem Ausgangszeitintervall [0, T], welches in N Teilintervalle unterteilt ist, wobei T eine vorgegebene Zeitdauer ist,
-- $\tilde{x}_{\tau_{n+1}}$ eine Realisierung des Näherungsprozesses an einer Stützstelle $\tau_{n+1}$,
-- $\tilde{x}_{\tau_n}$ eine Realisierung des Näherungsprozesses an einer Stützstelle $\tau_n$,
-- $\tilde{x}_{\tau_{n-1}}$ eine Realisierung des Näherungsprozesses an einer Stützstelle $\tau_{n-1}$,
-- ein Differenzwert $\Delta W_{n-1} := W_{\tau_n} - W_{\tau_{n-1}}$ zwischen einem zweiten Wert $W_{\tau_n}$ an der Stützstelle $\tau_n$ und dem zweiten Wert $W_{\tau_{n-1}}$ an der Stützstelle $\tau_{n-1}$

bezeichnet wird, und

- bei dem durch iterative Lösung des Näherungsprozesses die Störung $\tilde{x}_{\tau_{n+1}}$ ermittelt wird.

**2.** Verfahren nach Anspruch 1,
bei dem die Störung Rauschen ist, dem das System unterliegt.

**3.** Verfahren nach Anspruch 1 oder 2,
bei dem die Störung rein additiv ist.

**4.** Verfahren nach einem der Ansprüche 1 bis 3,
bei dem die Störung pfadweise ermittelt wird.

**5.** Verfahren nach einem der Ansprüche 1 bis 4,
bei dem ein stetiger Näherungsprozeß $\{\tilde{x}_s;\ s \in [0,T]\}$ ermittelt wird, indem die ermittelten Realisierungen des Näherungsprozesses interpoliert werden.

**6.** Verfahren nach Anspruch 4 und 5,
bei dem die ermittelten Pfade mit einem statistischen Verfahren analysiert werden.

**7.** Verfahren nach einem der Ansprüche 1 bis 6,
bei dem das System eine elektrische Schaltung ist.

**8.** Verfahren nach einem der Ansprüche 1 bis 6,
bei dem das System ein mechanisches Mehrkörpersystem ist.

**9.** Verfahren nach einem der Ansprüche 1 bis 6,
bei dem das System ein physikalisches System ist.

**10.** Verfahren nach einem der Ansprüche 1 bis 6,
bei dem das System ein chemisches System ist.

**11.** Verfahren nach einem der Ansprüche 1 bis 6,
bei dem das System ein physikalisch-chemisches System ist.

**12.** Vorrichtung zur Ermittlung einer Störung eines technischen Systems, welches einer Störung unterliegt,
bei der eine Prozessoreinheit vorgesehen ist, die derart eingerichtet ist, daß

- das System mittels eines impliziten stochastischen Differentialgleichungssystems beschrieben wird, welches folgende Form aufweist:

$$C * \dot{x}(t) + G * x(t) + s(t) + B * v(t) = 0,$$

  wobei mit C eine erste Matrix, mit $x(t)$ eine Ableitung eines Zustands des Systems nach einer Zeit, welche durch eine Zeitvariable t beschrieben wird, mit G eine zweite Matrix, mit $s(t)$ eine Systemfunktion von unabhängigen Systemgrößen, mit B eine dritte Matrix und mit $v(t)$ eine Störfunktion bezeichnet wird,
- eine näherungsweise Lösung des impliziten stochastischen Differentialgleichungssystems ermittelt wird, indem ein diskreter Näherungsprozeß realisiert wird,
- **dadurch gekennzeichnet daß** der diskrete Näherungsprozeß gemäß folgender Vorschrift (103) realisiert wird:

$$\begin{aligned}(C + h\alpha_2 G) \cdot \tilde{X}_{\tau_{n+1}} = \; & \left\{-(1-\gamma)C + h(1+\gamma\alpha_1-\alpha_2)G\right\} \cdot \tilde{X}_{\tau_n} + \\ & +\left\{-\gamma C + h(\gamma-\alpha_1\gamma)G\right\} \cdot \tilde{X}_{\tau_{n-1}} + \\ & +h\alpha_2 s(\tau_{n+1}) + h(1+\gamma\alpha_1-\alpha_2)s(\tau_n) + \\ & +h(\gamma-\alpha_1\gamma)s(\tau_{n-1}) + \\ & +B(\tau_n) \cdot \Delta W_n + \gamma B(\tau_n) \cdot \Delta W_{n-1}\end{aligned}$$

wobei mit

- -- $\alpha_1$, $\alpha_2$, $\gamma$ vorgegebene Parameter aus dem Intervall [0, 1],
- -- $h := \frac{T}{N}$, eine Schrittweite in einem Ausgangszeitintervall [0, T], welches in N Teilintervalle unterteilt ist, wobei T eine vorgegebene Zeitdauer ist,
- -- $\tilde{x}_{\tau_{n+1}}$ eine Realisierung des Näherungsprozesses an einer Stützstelle $\tau_{n+1}$,
- -- $\tilde{x}_{\tau_n}$ eine Realisierung des Näherungsprozesses an einer Stützstelle $\tau_n$,
- -- $\tilde{x}_{\tau_{n-1}}$ eine Realisierung des Näherungsprozesses an einer Stützstelle $\tau_{n-1}$,
- -- ein Differenzwert $\Delta W_{n-1} := W_{\tau n} - W_{\tau_{n-1}}$ zwischen einem zweiten Wert $W_{\tau_n}$ an der Stützstelle $\tau_n$ und dem zweiten Wert $W_{\tau_{n-1}}$ an der Stützstelle $\tau_{n-1}$

bezeichnet wird, und

- bei dem durch iterative Lösung des Näherungsprozesses die Störung $\tilde{x}_{\tau_{n+1}}$ ermittelt wird.

**13.** Vorrichtung nach Anspruch 12,
bei der die Störung Rauschen ist, dem das System unterliegt.

**14.** Vorrichtung nach Anspruch 12 oder 13,
bei der die Störung rein additiv ist.

**15.** Vorrichtung nach einem der Ansprüche 12 bis 14,
bei der die Prozessoreinheit derart eingerichtet ist, daß die Störung pfadweise ermittelt wird.

**16.** Vorrichtung nach einem der Ansprüche 12 bis 15,
bei der die Prozessoreinheit derart eingerichtet ist, daß ein stetiger Näherungsprozeß

$$\{\tilde{X}_s ; s \in [0, T]\}$$

ermittelt wird, indem die ermittelten Realisierungen des Näherungsprozesses interpoliert werden.

**17.** Vorrichtung nach Anspruch 15 und 16,
bei der die Prozessoreinheit derart eingerichtet ist, daß die ermittelten Pfade mit einem statistischen Verfahren analysiert werden.

**18.** Vorrichtung nach einem der Ansprüche 12 bis 17,
bei dem das System eine elektrische Schaltung ist.

**19.** Vorrichtung nach einem der Ansprüche 12 bis 17,
bei dem das System ein mechanisches Mehrkörpersystem ist.

**20.** Vorrichtung nach einem der Ansprüche 12 bis 17,
bei dem das System ein physikalisches System ist.

**21.** Vorrichtung nach einem der Ansprüche 12 bis 17,
bei dem das System ein chemisches System ist.

**22.** Vorrichtung nach einem der Ansprüche 12 bis 17,
bei dem das System ein physikalisch-chemisches System ist.

### Claims

**1.** Method for determining a disturbance in a technical system which is subject to the disturbance,

- in which the system is described by means of an implicit stochastic system of differential equations which have the following form:

- $C^*x(t)+G^*x(t)+s(t)+B^*v(t)=0$,
- C denoting a first matrix, x(t) denoting a derivative of a state of the system after a time which is described by a time variable t, G denoting a second matrix, s(t) denoting a system function of independent system variables, B denoting a third matrix, and v(t) denoting an interference function,
- in which an approximate solution of the implicit stochastic system of differential equations is determined by implementing a discrete approximation process,

**characterized in that** the discrete approximation process is implemented in accordance with the following rule (103) :

$$\begin{aligned}(C+h\alpha_2 G)\cdot \tilde{X}_{\tau_{n+1}} = \; & \{-(1-\gamma)C+h(1+\gamma\alpha_1-\alpha_2)G\}\cdot\tilde{X}_{\tau_n} + \\ & +\{-\gamma C+h(\gamma-\alpha_{1\gamma})G\}\cdot\tilde{X}_{\tau_{n-1}} + \\ & +h\alpha_2 s(\tau_{n+1})+h(1+\gamma\alpha_1-\alpha_2)s(\tau_n) + \\ & +h(\gamma-\alpha_{1\gamma})s(\tau_{n-1}) + \\ & +B(\tau_n)\cdot\Delta W_n+\gamma B(\tau_n)\cdot\Delta W_n-1\end{aligned}$$

where

-- $\alpha_1$, $\alpha_2$, $\gamma$ denote prescribed parameters from the interval [0,1],
-- $h:=\frac{T}{N}$, denotes a step width in an initial time interval [0,T] which is subdivided into N sub intervals, T being a prescribed time duration,
-- $\tilde{x}_{\tau_{n+1}}$ denotes an implementation of the approximation process at an interpolation point $\tau_{n+1}$,
-- $\tilde{x}_{\tau_n}$ denotes an implementation of the approximation process at an interpolation point $\tau_n$,
-- $\tilde{x}_{\tau_{n-1}}$ denotes an implementation of the approximation process at an interpolation point $\tau_{n-1}$,
-- a difference value $\Delta W_{n-1} := W_{\tau_n} - W_{\tau_{n-1}}$ between a second value $W_{\tau_n}$ at the interpolation point $\tau_n$ and the second value $W_{\tau_{n-1}}$ at the interpolation point $\tau_{n-1}$,

and

- in which the disturbance $\tilde{x}_{\tau_{n+1}}$ is determined by interative solution of the approximation process.

**2.** Method according to Claim 1, in which the disturbance is noise to which the system is subjected.

**3.** Method according to Claim 1 or 2, in which the disturbance is purely additive.

**4.** Method according to one of Claims 2 to 3, in which the disturbance is determined in a pathwise fashion.

**5.** Method according to one of Claims 1 to 4, in which a continuous approximation process $\{\tilde{x}_s; s\in[0,T]\}$ is determined by interpolation of the determined implementations of the approximation process.

**6.** Method according to Claims 4 and 5, in which the determined paths are analyzed using a statistical method.

**7.** Method according to one of Claims 1 to 6, in which the system is an electric circuit.

**8.** Method according to one of Claims 1 to 6, in which the system is a mechanical many-body system.

**9.** Method according to one of Claims 1 to 6, in which the system is a physical system.

**10.** Method according to one of Claims 1 to 6, in which the system is a chemical system.

**11.** Method according to one of Claims 1 to 6, in which the system is a physicochemical system.

**12.** Device for determining a disturbance in a technical system which is subject to a disturbance, in which a processor

unit is provided which is set up in such a way that

- the system is described by means of an implicit stochastic system of differential equations which has the following form:

- C*x(t)+G*x(t)+s(t)+B*v(t)=0,
- C denoting a first matrix, x(t) denoting a derivative of a state of the system after a time which is described by a time variable t, G denoting a second matrix, s(t) denoting a system function of independent system variables, B denoting a third matrix, and v(t) denoting an interference function,
- an approximate solution of the implicit stochastic system of differential equations is determined by implementing a discrete approximation process,
  **characterized in that** the discrete approximation process is implemented in accordance with the following rule (103):

$$-(C+h\alpha_2 G)\cdot \tilde{X}_{\tau_{n+1}} = \{-(1-\gamma)C+h(1+\gamma\alpha_1-\alpha_2)G\}\cdot \tilde{X}_{\tau_n} + \{-\gamma C+h(\gamma-\alpha_{1\gamma})G\}\cdot \tilde{X}_{\tau_{n-1}} + h\alpha_2 s(\tau_{n+1}) + h(1+\gamma\alpha_1-\alpha_2)s(\tau_n) + h(\gamma-\alpha_{1\gamma})s(\tau_{n-1}) + B(\tau_n)\cdot\Delta W_n + \gamma B(\tau_n)\cdot\Delta W_n - 1$$

  where

  -- $\alpha_1$, $\alpha_2$, $\gamma$ denote prescribed parameters from the interval [0,1],
  -- $h:=\frac{T}{N}$, denotes a step width in an initial time interval [0,T] which is subdivided into N sub intervals, T being a prescribed time duration,
  -- $\tilde{x}_{\tau_{n+1}}$ denotes an implementation of the approximation process at an interpolation point $\tau_{n+1}$.
  -- $\tilde{x}_{\tau_n}$ denotes an implementation of the approximation process at an interpolation point $\tau_n$,
  -- $\tilde{x}_{\tau_{n-1}}$ denotes an implementation of the approximation process at an interpolation point $\tau_{n-1}$.
  -- a difference value $\Delta W_{n-1} := W_{\tau_n} - W_{\tau_{n-1}}$ between a second value $W_{\tau_n}$ at the interpolation point $\tau_n$ and the second value $W_{\tau_{n-1}}$ at the interpolation point $\tau_{n-1}$.

and

- in which the disturbance $\tilde{x}_{\tau_{n+1}}$ is determined by interative solution of the approximation process.

**13.** Device according to Claim 12, in which the disturbance is noise to which the system is subjected.

**14.** Device according to Claim 12 or 13, in which the disturbance is purely additive.

**15.** Device according to one of Claims 12 to 14, in which the processor unit is set up in such a way that the disturbance is determined in a pathwise fashion.

**16.** Device according to one of Claims 12 to 14, in which the processor unit is set up in such a way that a continuous approximation process $\{\tilde{x}_s; s\in[0,T]\}$ is determined by interpolation of the determined implementations of the approximation process.

**17.** Device according to Claims 15 and 16, in which the processor unit is set up in such a way that the determined paths are analyzed using a statistical method.

**18.** Device according to one of Claims 12 to 17, in which the system is an electric circuit.

**19.** Device according to one of Claims 12 to 17, in which the system is a mechanical many-body system.

**20.** Device according to one of Claims 12 to 17, in which the system is a physical system.

**21.** Device according to one of Claims 12 to 17, in which the system is a chemical system.

**22.** Device according to one of Claims 12 to 17, in which the system is a physicochemical system.

## Revendications

**1.** Procédé pour la détermination d'une perturbation d'un système technique qui est soumis à une perturbation,

- dans lequel on décrit le système au moyen d'un système d'équations différentielles stochastique implicite qui a la forme suivante :

$$C * \dot{x}(t) + G * x(t) + s(t) + B * v(t) = 0$$

C étant une première matrice, $\dot{x}$ (t) étant une dérivée d'un état du système par rapport au temps qui est décrit par une variable de temps t, G étant une deuxième matrice, s(t) étant une fonction de système de grandeurs de système indépendantes, B étant une troisième matrice et v(t) étant une fonction de perturbation,
- dans lequel on détermine une solution approximative du système d'équations différentielles stochastique implicite en réalisant un processus d'approximation discret,
- **caractérisé par le fait qu'**on réalise le processus d'approximation discret selon la règle (103) suivante :

$$\begin{aligned}(C + h\alpha_2 G) \cdot \tilde{X}_{\tau_{n+1}} &= \{-(1-\gamma)C + h(1+\gamma\alpha_1-\alpha_2)G\} \cdot \tilde{X}_{\tau_n} + \\ &+ \{-\gamma C + h(\gamma - \alpha_{1\gamma})G\} \cdot \tilde{X}_{\tau_{n-1}} + \\ &+ h\alpha_2 s(\tau_{n+1}) + h(1+\gamma\alpha_1-\alpha_2)s(\tau_n) + \\ &+ h(\gamma-\alpha_{1\gamma})s(\tau_{n-1}) + \\ &+ B(\tau_n) \cdot \Delta W_n + \gamma B(\tau_n) \cdot \Delta W_{n-1}\end{aligned}$$

avec

-- $\alpha_1$, $\alpha_2$, $\gamma$ des paramètres prédéterminés dans un intervalle [0, 1],
-- $h := \frac{T}{N}$ une largeur de pas dans un intervalle de temps de sortie [0, T] qui est divisé en N sous-intervalies, T étant une durée prédéterminée,
-- $\tilde{x}_{\tau_{n+1}}$ une réalisation du processus d'approximation en un point de référence $\tau_{n+1}$,
-- $\tilde{x}_{\tau_n}$ une réalisation du processus d'approximation en un point de référence $\tau_n$,
-- $\tilde{x}_{\tau_{n-1}}$ une réalisation du processus d'approximation en un point de référence $\tau_{n-1}$,
-- une valeur de différence $\Delta W_{n-1} := W_{\tau_n} - W_{\tau_{n-1}}$ entre une deuxième valeur $W_{\tau_n}$ au point de référence $\tau_n$ et la deuxième valeur $W_{\tau_{n-1}}$ au point de référence $\tau_{n-1}$,

et

- on détermine la perturbation $\tilde{x}_{\tau_{n+1}}$ par une résolution itérative du processus d'approximation.

**2.** Procédé selon la revendication 1,
dans lequel la perturbation est du bruit auquel le système est soumis.

**3.** Procédé selon l'une des revendications 1 ou 2,

dans lequel la perturbation est purement additive.

**4.** Procédé selon l'une des revendications 1 à 3, dans lequel la perturbation est déterminée par chemins.

**5.** Procédé selon l'une des revendications 1 à 4, dans lequel on détermine un processus d'approximation $\{\tilde{x}_s ; s \in [0, T]\}$ en interpolant les réalisations déterminées du processus d'approximation.

**6.** Procédé selon les revendications 4 et 5, dans lequel on analyse les chemins déterminés avec un procédé statistique.

**7.** Procédé selon l'une des revendications 1 à 6, dans lequel le système est un circuit électrique.

**8.** Procédé selon l'une des revendications 1 à 6, dans lequel le système est un système mécanique à plusieurs corps.

**9.** Procédé selon l'une des revendications 1 à 6, dans lequel le système est un système physique.

**10.** Procédé selon l'une des revendications 1 à 6, dans lequel le système est un système chimique.

**11.** Procédé selon l'une des revendications 1 à 6, dans lequel le système est un système physicochimique.

**12.** Dispositif pour la détermination d'une perturbation d'un système technique qui est soumis à une perturbation, dans lequel il est prévu une unité à processeur telle que

- le système est décrit au moyen d'un système d'équations différentielles stochastique implicite qui a la forme suivante :

$$C * \dot{x}(t) + G * x(t) + s(t) + B * v(t) = 0$$

C étant une première matrice, $\dot{x}$ (t) étant une dérivée d'un état du système par rapport au temps, qui est décrit par une variable de temps t, G étant une deuxième matrice, s(t) étant une fonction de système de grandeurs de système indépendantes, B étant une troisième matrice et v(t) étant une fonction de perturbation,
- une solution approximative du système d'équations différentielles stochastique implicite est déterminée en réalisant un processus d'approximation discret,
- **caractérisé par le fait que** le processus d'approximation discret est réalisé selon la règle (103) suivante :

$$\begin{aligned}(C + h\alpha_2 G) \cdot \tilde{X}_{\tau_{n+1}} &= \{-(1 - \gamma)C + h(1 + \gamma\alpha_1 - \alpha_2)G\} \cdot \tilde{X}_{\tau_n} + \\ &+ \{-\gamma C + h(\gamma - \alpha_{1\gamma})G\} \cdot \tilde{X}_{\tau_{n-1}} + \\ &+ h\alpha_2 s(\tau_{n+1}) + h(1 + \gamma\alpha_1 - \alpha_2)s(\tau_n) + \\ &+ h(\gamma - \alpha_{1\gamma})s(\tau_{n-1}) + \\ &+ B(\tau_n) \cdot \Delta W_n + \gamma B(\tau_n) \cdot \Delta W_{n-1}\end{aligned}$$

avec

-- $\alpha_1$, $\alpha_2$, $\gamma$ des paramètres prédéterminés dans un intervalle [0, 1],
-- $h := \frac{T}{N}$ une largeur de pas dans un intervalle de temps de sortie [0, T] qui est divisé en N sous-intervalles,

T étant une durée prédéterminée,

- $\tilde{x}_{\tau_{n+1}}$ une réalisation du processus d'approximation en un point de référence $\tau_{n+1}$,
- $\tilde{x}_{\tau_n}$ une réalisation du processus d'approximation en un point de référence $\tau_n$,
- $\tilde{x}_{\tau_{n-1}}$ une réalisation du processus d'approximation en un point de référence $\tau_{n-1}$,
- une valeur de différence $\Delta W_{n-1} := W_{\tau_n} - W_{\tau_{n-1}}$ entre une deuxième valeur $W_{\tau_n}$ au point de référence $\tau_n$ et la deuxième valeur $W_{\tau_{n-1}}$ au point de référence $\tau_{n-1}$,

et

- la perturbation $\tilde{x}_{\tau_{n+1}}$ est déterminée par une résolution itérative du processus d'approximation.

**13.** Dispositif selon la revendication 12,
dans lequel la perturbation est du bruit auquel le système est soumis.

**14.** Dispositif selon la revendication 12 ou 13,
dans lequel la perturbation est purement additive.

**15.** Dispositif selon l'une des revendications 12 à 14,
dans lequel la perturbation est déterminée par chemins.

**16.** Dispositif selon l'une des revendications 12 à 15,
dans lequel on détermine un processus d'approximation $\{\tilde{x}_s ; s \in [0, T]\}$ en interpolant les réalisations déterminées du processus d'approximation.

**17.** Dispositif selon les revendications 15 et 16,
dans lequel on analyse les chemins déterminés avec un procédé statistique.

**18.** Dispositif selon l'une des revendications 12 à 17,
dans lequel le système est un circuit électrique.

**19.** Dispositif selon l'une des revendications 12 à 17,
dans lequel le système est un système mécanique à plusieurs corps.

**20.** Dispositif selon l'une des revendications 12 à 17,
dans lequel le système est un système physique.

**21.** Dispositif selon l'une des revendications 12 à 17,
dans lequel le système est un système chimique.

**22.** Dispositif selon l'une des revendications 12 à 17,
dans lequel le système est un système physicochimique.

FIG 1

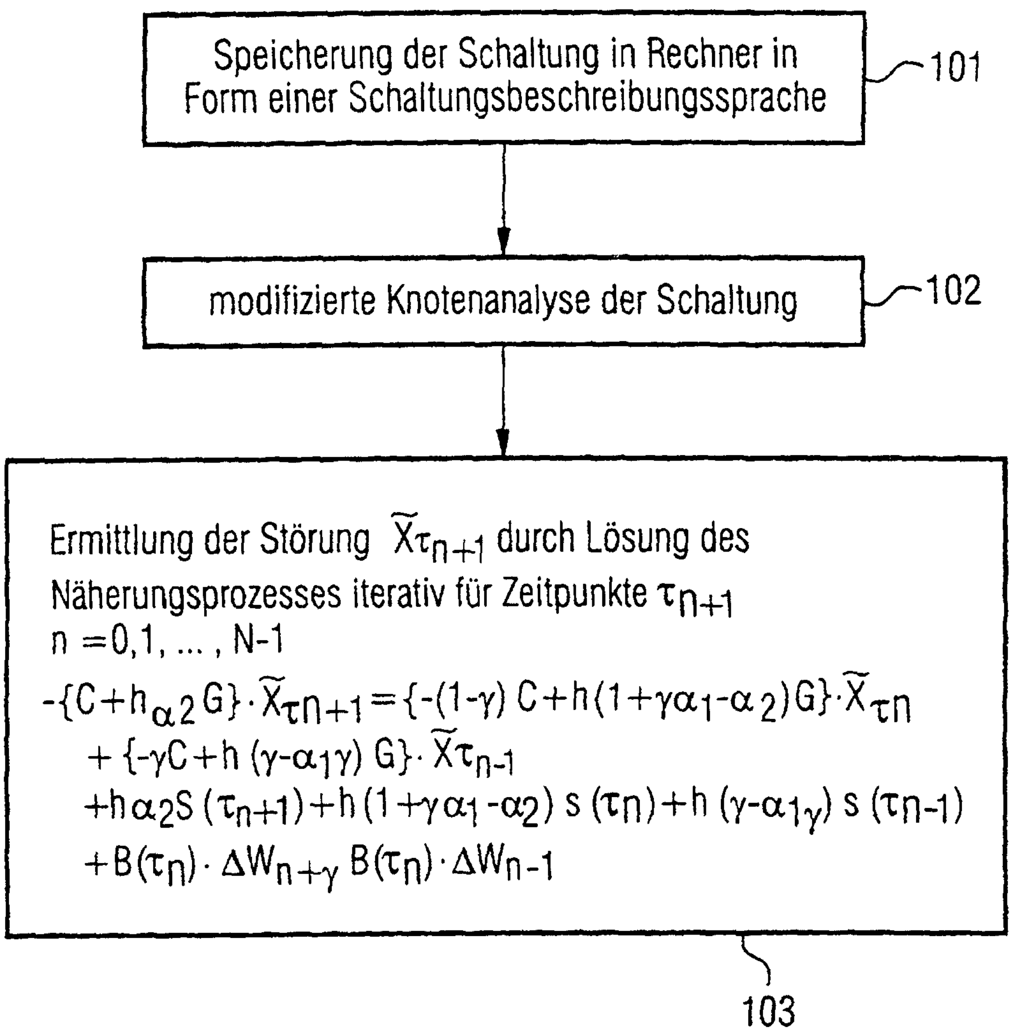
Speicherung der Schaltung in Rechner in Form einer Schaltungsbeschreibungssprache
101
modifizierte Knotenanalyse der Schaltung
102
Ermittlung der Störung $\tilde{X}_{\tau_{n+1}}$ durch Lösung des Näherungsprozesses iterativ für Zeitpunkte $\tau_{n+1}$
$n = 0, 1, \dots, N-1$
$-\{C + h\alpha_2 G\} \cdot \tilde{X}_{\tau n+1} = \{-(1-\gamma) C + h(1+\gamma\alpha_1 - \alpha_2) G\} \cdot \tilde{X}_{\tau n}$
$+ \{-\gamma C + h(\gamma - \alpha_1\gamma) G\} \cdot \tilde{X}_{\tau_{n-1}}$
$+ h\alpha_2 S(\tau_{n+1}) + h(1+\gamma\alpha_1 - \alpha_2) s(\tau_n) + h(\gamma - \alpha_{1\gamma}) s(\tau_{n-1})$
$+ B(\tau_n) \cdot \Delta W_{n+\gamma} B(\tau_n) \cdot \Delta W_{n-1}$
103

FIG 2

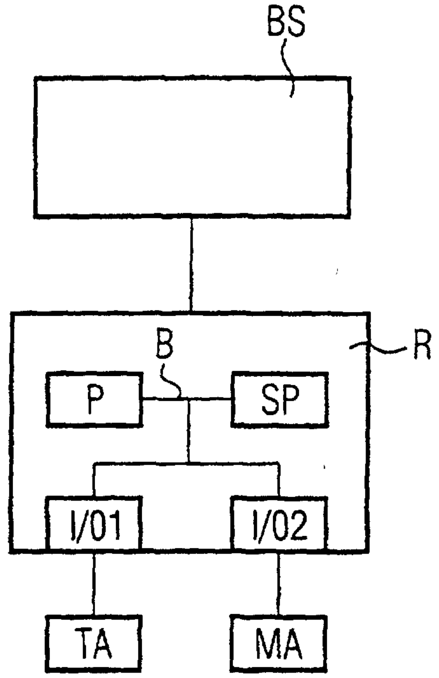


FIG 3

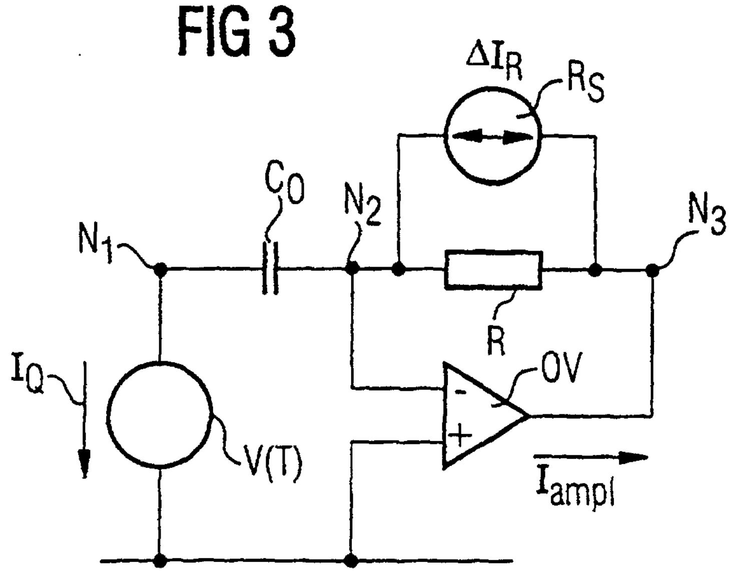

FIG 4

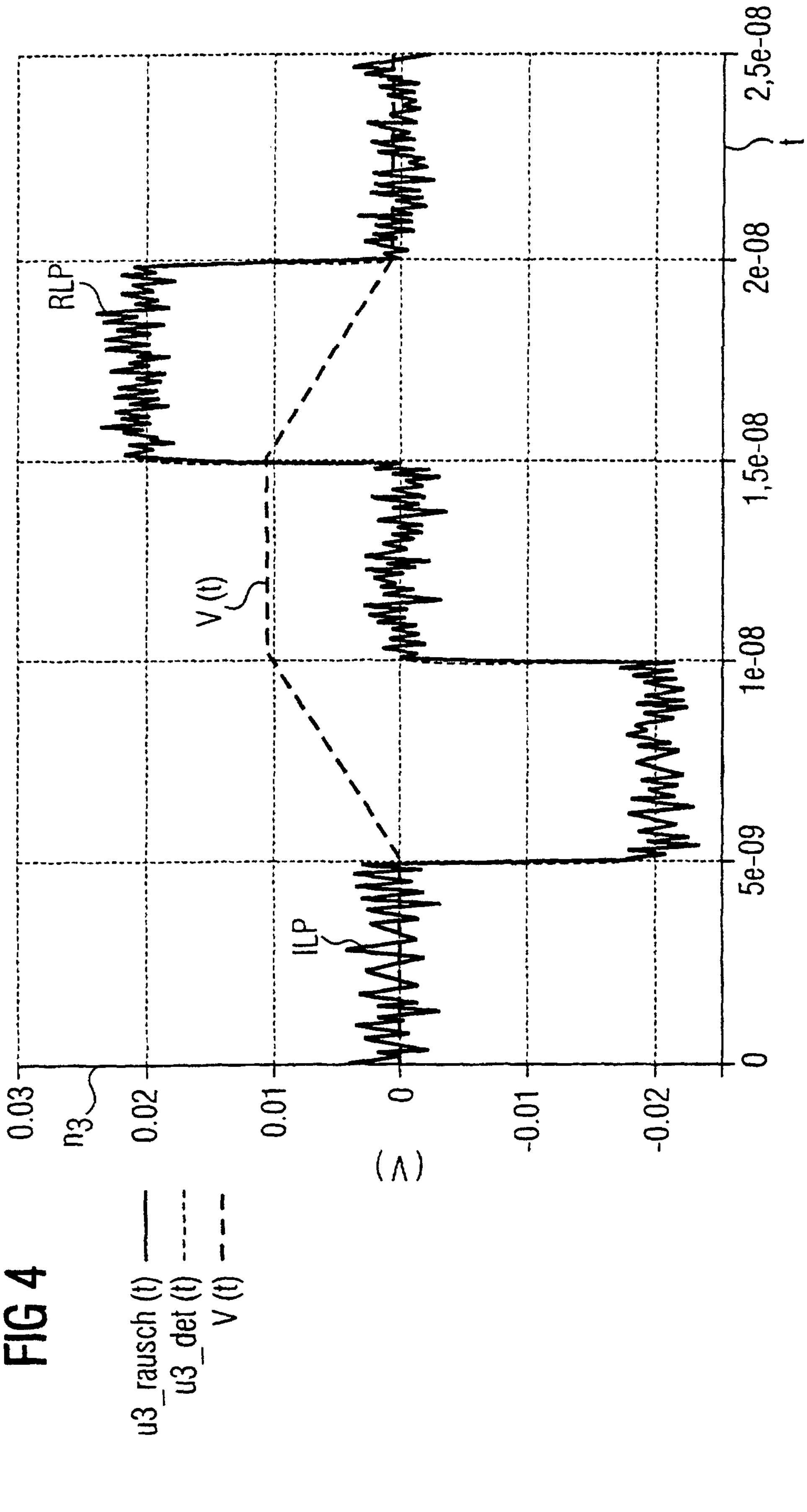
u3_rausch (t)
u3_det (t)
V (t)
0.03
0.02
0.01
0
-0.01
-0.02
(V)
n3
0
5e-09
1e-08
1,5e-08
2e-08
2,5e-08
t
ILP
RLP
V (t)